(19) Europäisches Patentamt
European Patent Office
Office européen des brevets

(11) Publication number: 0 349 269 B1

# (12) EUROPEAN PATENT SPECIFICATION

(45) Date of publication of patent specification: 15.06.94

(51) Int. Cl.5: H05K 1/03, C08L 79/08, B05D 7/00

(21) Application number: 89306514.4

(22) Date of filing: 27.06.89

## (54) Flexible copper-clad substrates.

(30) Priority: 30.06.88 JP 162982/88
29.08.88 JP 214185/88

(43) Date of publication of application:
03.01.90 Bulletin 90/01

(45) Publication of the grant of the patent:
15.06.94 Bulletin 94/24

(84) Designated Contracting States:
CH DE FR GB LI

(56) References cited:
EP-A- 0 089 387
EP-A- 0 133 533
EP-A- 0 189 643
EP-A- 0 194 865
EP-A- 0 270 672
DE-A- 3 215 944

(73) Proprietor: Chisso Corporation
6-32, Nakanoshima 3-chome
Kita-ku
Osaka-shi Osaka-fu(JP)

(72) Inventor: Konotsune, Shiro
12-6, Hairando 5-chome
Yokosuka-shi Kanagawa-ken(JP)
Inventor: Kituta, Kazutsune
8890, Goi
Ichihara-hi Chiba-ken(JP)
Inventor: Uetsuki, Masaya
2-17, Tatsumidaihigashi
Ichihara-shi Chiba-ken(JP)
Inventor: Hase, Hiroaki
2-17, Tatsumidaihigashi
Ichihara-shi Chiba-ken(JP)

(74) Representative: Lamb, John Baxter et al
MARKS & CLERK,
57-60 Lincoln's Inn Fields
London WC2A 3LS (GB)

EP 0 349 269 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to flexible copper-clad substrates having good dimensional stability and adhesive properties and to a process for making such substrates.

Flexible copper-clad substrates are etched to form circuits, and various electronic parts are mounted on the circuits. Afterward, the circuits are incorporated in a system. In recent years, the mounting density of the parts on this type of circuit substrates has increased more and more, and the mounting procedure has tended to become automated. The mounting is effected under high-temperature conditions, e.g. by the use of automatic soldering, and therefore the substrates are required to have heat resistance. In addition, in the processes of forming the circuits, the substrates suffer chemical and thermal changes such as etching and washing, and so it is necessary that they maintain their original plane form without curling and without peeling of copper from films.

In most cases, conventional polyimide flexible printed substrates comprise polyimide films and copper foils clad thereon by means of an adhesive. However, with regard to this type of substrate, their heat resistance and electrical characteristics change inconveniently with time because of the adhesive, and for this reason, these substrates are not generally suitable for high-density circuits and automatic mounting systems. In order to solve these problems, some techniques have been suggested including a method for thermally fusing polyimide films onto copper foils (Japanese Laid-Open patent No. 181857/1982) and a method which comprises coating copper foils with a polyimide precursor solution, and then heating to form a polyimide film thereon (Japanese Laid-Open patent No. 111359/1986).

These improved methods, since they use no adhesive, can provide substrates having good heat resistance and electrical characteristics, but the first method requires a thermal fusing step and other related steps, and thus the same or more treatment steps as in the conventional case are necessary. Furthermore, there is the problem that when the polyimide films which have undergone the thermal fusing treatment at a high temperature are cooled to room temperature, the substrates tend to curl owing to the difference between the thermal expansion coefficients of the resin and the copper foil. On the other hand, the second method has no step of preparing any film, and the steps of this method can be simplified. However, since a high temperature is required in the polyimide formation step, the substrates similarly tend to curl when cooled to room temperature. In addition, there is also the problem that the adhesive strength between the polyimide film and the copper foil may not be sufficient.

As discussed above, in the suggested methods, the substrates tend to curl when the adhesive strength of the polyimide to the copper foil is increased, and the adhesive strength deteriorates when the thermal expansion coefficient is controlled. In consequence, the known methods which have such problems are not sufficiently practical.

It is an object of the present invention to provide substrates which have high adhesive strength and which scarcely curl. Another object of the present invention is to provide a process for preparing such substrates.

According to one embodiment of the invention there is provided a flexible copper-clad substrate which comprises a copper foil having formed directly on its surface a resin layer of a composite of (I) a polyimide having repeating units of the formula:

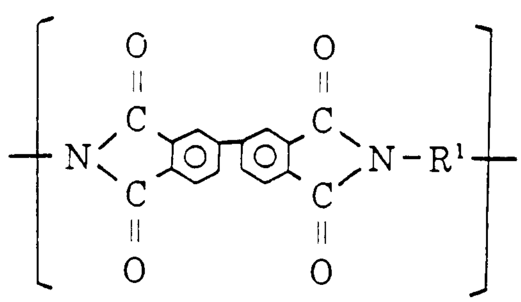

(I)

[in which $R^1$ is an aromatic hydrocarbon groupof the formula:

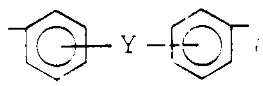 and/or 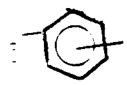

in which Y is -O-, -CO-, $-SO_2-$ or $-CH_2-$]; and (II) a silicone polyimide containing repeating units of the formula:

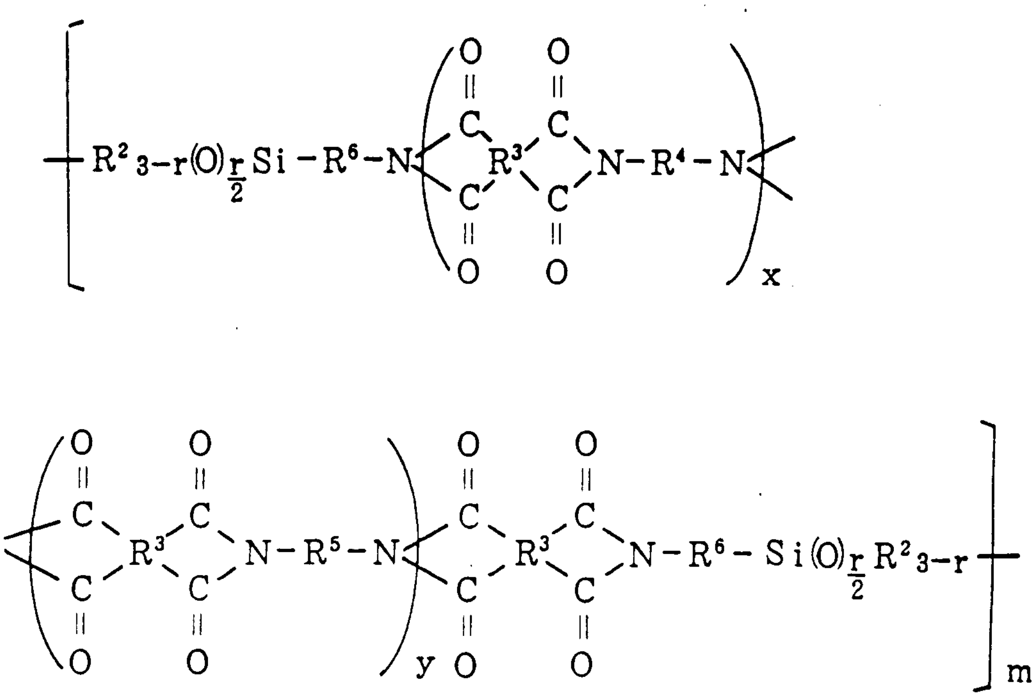

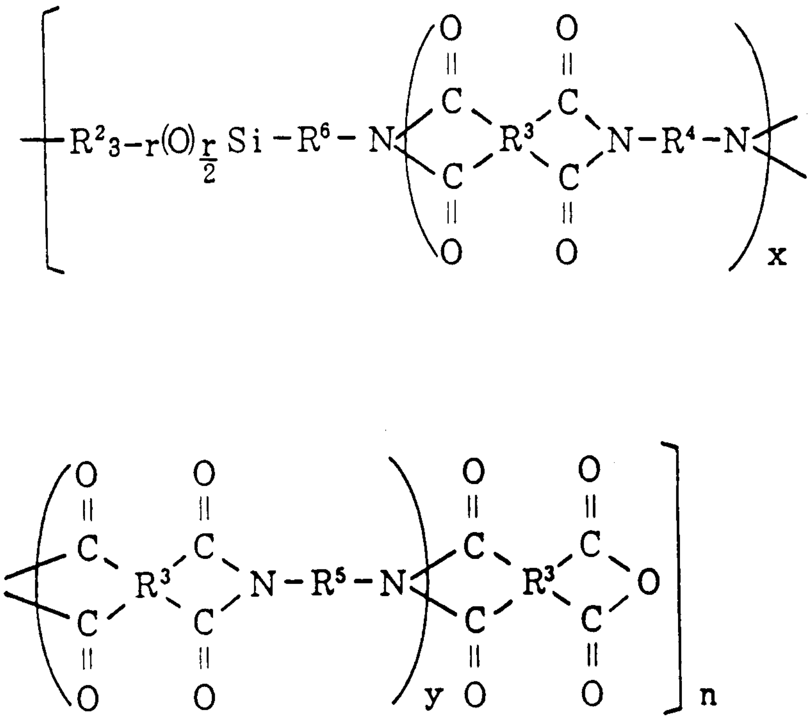

(II)

(in which $R^2$ is an aliphatic hydrocarbon group having 5 or less carbon atoms or an aromatic hydrocarbon group having 9 or less carbon atoms; $R^3$ is a tetravalent aromatic hydrocarbonyl group; $R^4$ is a divalent aromatic hydrocarbon group; $R^5$ is divalent siloxane chain; $R^6$ is a divalent aliphatic hydrocarbon group having 3 to 5 carbon atoms or a divalent aromatic hydrocarbon group having 6 to 9 carbon atoms; r is 2 or 3; the ratio x:y is 97-60: 3-40, and the ratio m:n is 50-100:50-0.

In accordance with a preferred embodiment of the invention, $R^1$ is composed of 5 to 30 mole% of groups of the formula

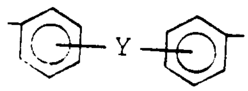

and 70 to 95 moles% of groups of the formula:

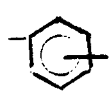 ;

$R^2$ is a methyl or phenyl group; and $R^5$ is a group of the formula:

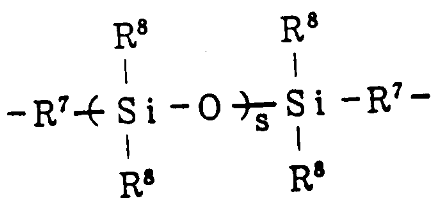

(V)

(in which $R^7$ is a divalent aliphatic hydrocarbon group having 3 to 5 carbon atoms or a divalent aromatic hydrocarbon group having 6 to 9 carbon atoms; $R^8$ is an aliphatic hydrocarbon group having 1 to 3 carbon atoms or an aromatic hydrocarbon group having 6 to 9 carbon atoms, and s is an integer of 3 to 150).

The invention also provides a process for preparing a flexible copper-clad substrate as defined above which comprises the steps of coating a copper foil with a composite polyamide acid solution and then forming the resin layer by heating the coated foil, the composite solution being one prepared by mixing a solution of a polyamide acid having repeating units of the formula:

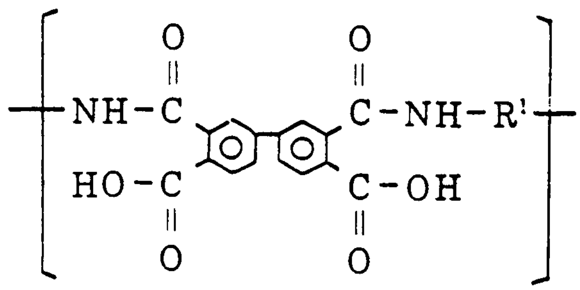

(III)

(in which $R^1$ has the meaning defined above), and a polyamide acid alkylsilane the formula:

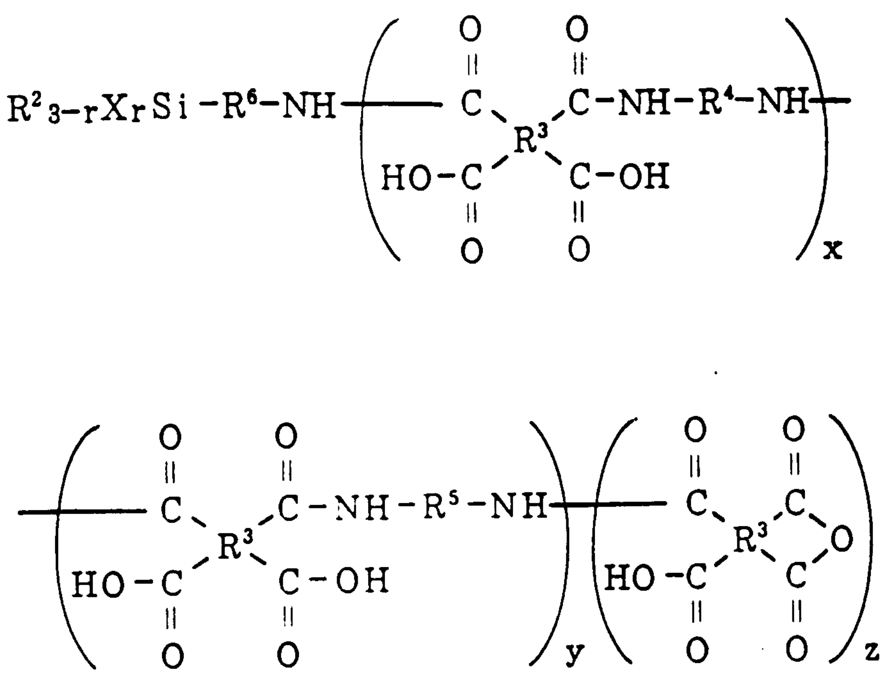

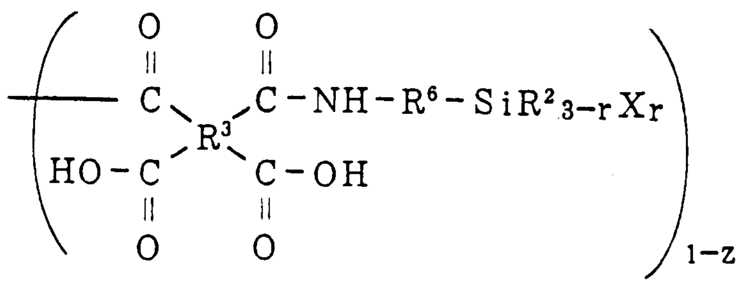

(IV)

(in which $R^1$, $R^2$, $R^3$, $R^4$, $R^5$, $R^6$, r, x and y are as defined above; X is a hydrolyzable alkoxy group, an acetoxy group or a halogen group; and z is a value of 0 to 0.5).

In a preferred embodiment of the process, $R^1$ is composed of 5 to 30 mole % of group

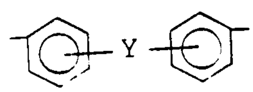

and 70 to 95 mole % of groups

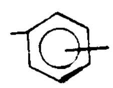

;

$R^2$ is a methyl or phenyl group; and
$R^5$ is a group of the formula:

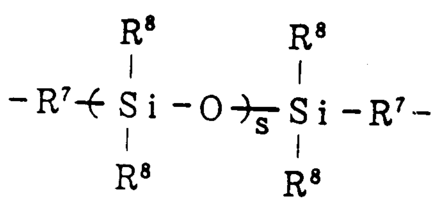

(V)

(in which $R^7$, $R^8$ and S have the meanings defined above).

A flexible copper-applied substrate of the present invention not only has high adhesive strength between a polyimide and a copper foil but also prevents curling substantially, and therefore it is practically valuable. This is attributable to a synergistic effect obtained from the composite material in which a polyimide chain of a stiff structure having a controlled linear expansion coefficient is firmly combined with a crosslinked polyimide having a flexible structure.

A polyamide acid (III) used in the present invention may be prepared by reacting 3,4,3',4'-biphenyltetracarboxylic acid dianhydride represented by the formula (VI)

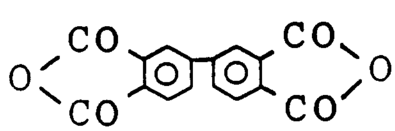

(VI)

with phenylenediamine represented by the general formula (VII)

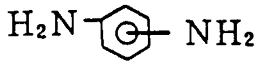

(VII)

and an aromatic diamine represented by the general formula (VIII)

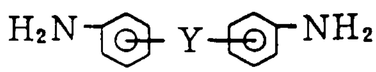

(VIII)

in a polar organic solvent.

Examples of the phenylenediamine used herein include paraphenylenediamine, metaphenylenediamine and orthophenylenediamine, but for the purpose of the present invention, paraphenylenediamine and a mixture of paraphenylenediamine and metaphenylenediamine can be suitably used. Furthermore, examples of the aromatic diamine represented by the formula (VIII) include 4,4′-diaminodiphenyl ether, 3,4′-diaminodiphenyl ether, 3,3′-diaminodiphenyl ether, 4,4′-diaminodiphenyl sulfone, 3,4′-diaminodiphenylsulfone, 4,4′-diaminodiphenyl ketone and 4,4′-diaminodiphenylmethane, but for the purpose of the present invcntion, 4,4′-diaminodiphenyl ether, 3,3′-diaminodiphenyl ether, 3,4′-diaminodiphenyl ether and mixtures thereof are suitable. The amounts of the above-mentioned diamines to be used are preferably such that a molar ratio of the diamine represented by the formula (VII) to the diamine represented by the formula (VIII) is in the range of 70-95:30-5.

Furthermore, the polyamide acid represented by the general formula (IV) may be prepared by reacting an aromatic tetracarboxylic dianhydride represented by the following general formula (IX), an aromatic diamine represented by the following general formula (X), $\alpha,\omega$-diaminosilicone represented by the general formula (XI) and an aminoalkylsilane represented by the following general formula (XII) in an organic solvent:

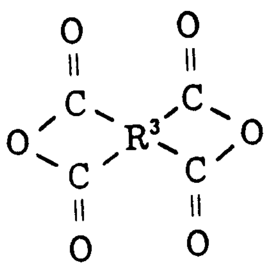

(IX)

$H_2N\text{-}R^4\text{-}NH_2$    (X)

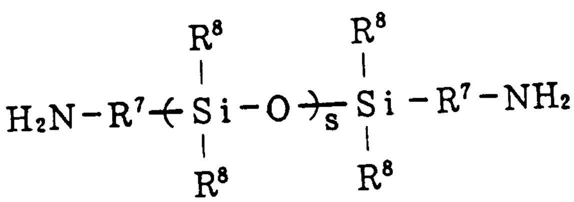

(XI)

$H_2N\text{-}R^6\text{-}SiR^2_{3-r}X_r$    (XII)

Typical examples of the aromatic tetracarboxylic acid dianhydride represented by the formula (IX) include pyromellitic acid dianhydride, 3,4,3′,4′-biphenyltetracarboxylic acid dianhydride, 3,4,3′,4′-benzophenonetetracarboxylic acid dianhydride, 2,3,3′,4′-benzophenonetetracarboxylic acid dianhydride, bis(3,4-dicarboxyphenyl)-ether dianhydride and bis(3,4-dicarboxyphenyl)-sulfone dianhydride. These carboxylic

dianhydrides can be singly or in combination.

Moreover, typical examples of the aromatic diamine represented by the formula (X) include paraphenylenediamine, metaphenylenediamine, 4,4'-diaminodiphenyl ether, 3,4'-diaminodiphenyl ether, 3,3'-diaminodiphenyl ether, 4,4'-diaminodiphenyl ketone, 3,4'-diaminodiphenyl ketone, 4,4'-diaminodiphenylsulfone, 4,4'-diaminobiphenyl, 3,4'-diaminobiphenyl, 4,4'-diaminodiphenylmethane, 2,2'-bis(4-aminophenyl)-propane, 1,4-di(4-aminophenyl)phenyl ether and 1,3-di(4-aminophenyl)phenyl ether. Furthermore, examples of α,ω-diaminosilicone represented by the general formula (XI) include the following compounds:

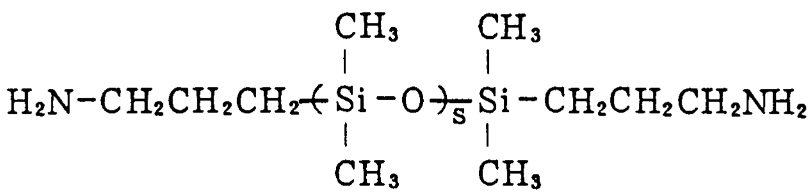

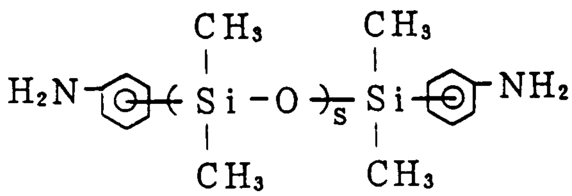

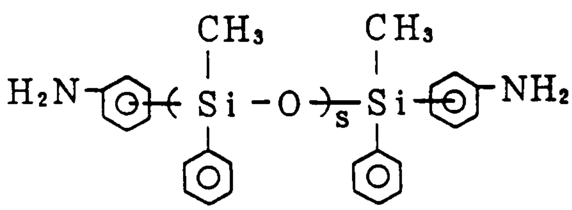

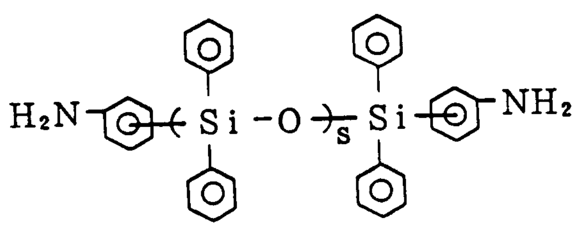

The amount of α,ω-diaminosilicone is preferably used in an amount of 3 to 40 mole% based on the total weight of all the diamines [the total of the aromatic diamine (X) and α,ω-diaminosilicone (XI)].

Typical examples of the aminoalkylsilane represented by the formula (XII) include the following compounds:

$H_2N\text{-}CH_2CH_2CH_2\text{-}Si(OCH_3)_3$,

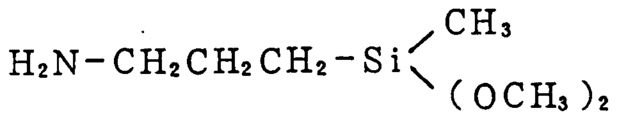 ,

$H_2N-CH_2CH_2CH_2-SiC\ell_3$ ,
$H_2N-CH_2CH_2CH_2CH_2CH_2-Si(OCH_3)_3$ ,

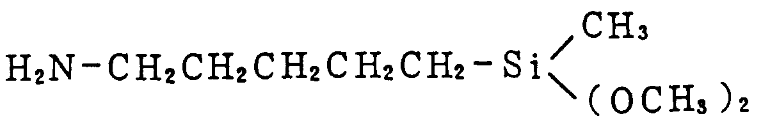 ,

$H_2N-CH_2CH_2CH_2CH_2CH_2-SiC\ell_3$ ,

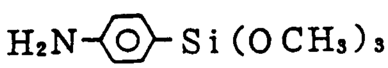 、 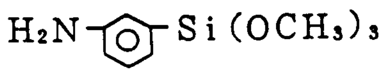 ,

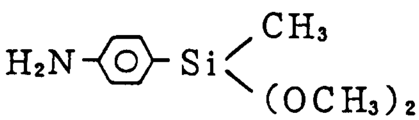 、 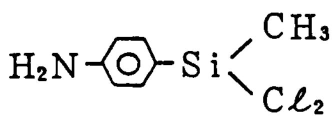 ,

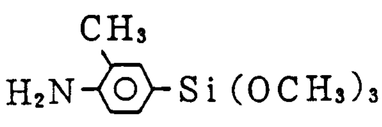 、 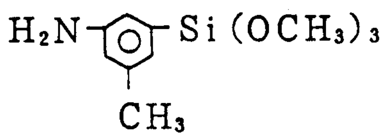 ,

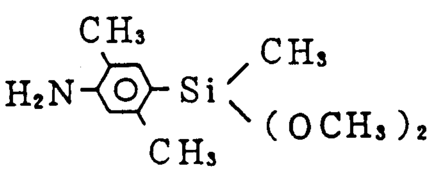 ,

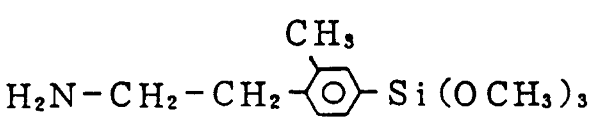 .

Of these compounds, what are particularly suitable for the purpose of the present invention are paraaminophenyltrimethoxysilane, metaaminophenyltrimethoxysilane, a mixture of paraminophenytrimethoxysilane and metaaminophenyltrimethoxysilane and paraaminophenyl-methyldimethoxysilane.

The amount of the aminoalkylsilane to be used is from 0.5 to 20 mole%, preferably 1 to 10 mole%, based on the total weight of the diamines.

Examples of the organic solvent used in the synthetic reaction of the polyamide acids (III) and (IV) include polar organic solvents such as N-methyl-2-pyrrolidone, N,N-dimethylacetamide, N,N-dimethylformamide, dimethylsulfoxide, cresol, ethylcarbitol and cyclopentanone, and they can be used singly or in the form of a mixture of two or more thereof. In addition, xylene, toluene, ethylene glycol monoethyl ether or the like may be mixed with the above-mentioned solvent.

Next, reference to synthetic conditions will be made. In the case that the polyamide acid (III) is synthesized, the diamines are dissolved in the polar solvent, and the diamino compounds and the equimolar tetracarboxylic dianhydride are added thereto in sequence with stirring in a nitrogen gas flow. Temperature is maintained at a level of 0 to 80 °C, and the reaction is performed for a period of 1 to 24 hours. The molecular weight of the resulting polyamide acid is preferably such that its inherent viscosity at 30 °C at a concentration of 0.5 g/100 ml in N-methyl-2-pyrrolidone is from 0.7 to 2.

The polyamide acid (IV) may be synthesized by a method in which the diamines (X), (XI) and the aminosilane (XII) are dissolved in an organic solvent, and a predetermined amount of tetracarboxylic dianhydride is further added thereto with stirring in a nitrogen gas flow, and in which the reaction temperature is maintained at a level of 0 to 80 °C, and reaction is performed for a period of 1 to 24 hours. Alternatively, the diamines (X) and (XI) are dissolved in the organic solvent, and a predetermined amount of tetracarboxylic dianhydride is added thereto with stirring in a nitrogen gas flow so as to perform reaction. Afterward, the aminoalkylsilane (XII) is further added thereto, and the reaction is carried out. The amounts of the respective components used in the reaction preferably satisfy the following relations:

$$1 \leqq \frac{D}{A-(B+C)} \leqq 2$$

$$0.001 \leqq \frac{D}{2B+2C+D} \leqq 0.1$$

wherein A, B, C and D represent moles of the tetracarboxylic dianhydride, moles of the aromatic diamine, moles of $\alpha,\omega$-diaminosilicone and moles of the aminoalkylsilane, respectively.

The polyamide acid (IV) obtained by this reaction preferably has an inherent viscosity of 0.05 to 1 at 30 °C at a concentration of 0.5 g/100 ml in N-methyl-2-pyrrolidone.

The polyamide acids (III) and (IV) prepared by the above-mentioned reaction are mixed preferably in a ratio which satisfies the formula

$$0.02 \leqq \frac{F}{E+F} \leqq 0.50$$

more preferably,

$$0.05 \leqq \frac{F}{E+F} \leqq 0.30$$

wherein E and F represent weights of the polyamide acids (III) and (IV), respectively,
and if desired, the above-mentioned reaction solvent is added thereto or removed therefrom, in order to form a polyamide acid composite solution, and a copper foil is then coated with the polyamide acid composite solution. A coating technique is not particularly limited, and a comma coating process, an extrusion cast process or the like can be employed.

After the coating step, a thermal treatment is carried out to form a polyimide. In this case, the treatment is stepwise performed at a temperature of 100 to 200 °C for a period of 10 to 90 minutes, and afterward at 200 to 350 °C for 10 to 270 minutes.

The flexible copper-applied substrate of the present invention is more excellent in adhesive strength and curl resistance as compared with a conventional substrate comprising a single polyimide resin layer and a copper foil. That is, in the present invcntion, the two kinds of polyimide resins are not simply mixed, and a synergistic effect due to the formation of the composite is exhibited. In consequence, according to the present invention, the substrates can be provided which have high adhesive strength and which prevent curling.

## EXAMPLES

Now, the present invention will be described in detail in reference to examples and comparative examples, but the scope of the present case should not be limited to these examples.

### Example 1

(1) Synthesis of polyamide acid (A):

A stirrer was set to a 500 milliliter three-necked flask, and the atmosphere in the flask was then replaced with nitrogen. Afterward, 250 ml of purified dimethylacetamide was poured into the flask. Additionally, 8.6 g of paraphenylenediamine and 4.0 g of 4,4′-diaminodiphenyl ether were then added thereto and dissolved therein. After the dissolution, while a reaction temperature was controlled so as not to exceed 10 °C, 29.4 g of 3,4,3′,4′-biphenyltetracarboxylic acid dianhydride was added thereto little by little with stirring to perform reaction. After completion of the addition, the reaction was carried out at a reaction temperature of 15 °C for 5 hours, so that a polyamide acid solution was obtained. The thus obtained polyamide acid had an inherent viscosity of 1.8 at 30 °C at a concentration of 0.5 g/dl in N-methyl-2-pyrrolidone.

(2) Synthesis of polyamide acid (B):

Into a 300 milliliter three-necked flask was poured purified 150 ml of N,N-dimethylacetamide, and 3.5 g of paraphenylenediamine and 10.3 g of $\alpha,\omega$-di-(3-aminopropyl)-polydimethylsiloxane were then dissolved therein. After the dissolution, 14.7 g of biphenyltetracarboxylic acid dianhydride was added thereto, and 0.6 g of aminophenyltrimethoxysilane was then added thereto in order to perform reaction. This reaction was carried out with stirring at 15 °C for 5 hours, thereby obtaining a polyamide acid, which had an inherent viscosity of 0.3 at 30 °C at a concentration of 0.5 g/dl in N-methyl-2-pyrrolidone.

(3) Substrate:

The polyamide acid solutions (A) and (B) which had been synthesized in the above-mentioned steps (1) and (2) were mixed uniformly in a polmer weight ratio of 4:1. Afterward, the mixed polyamide acid solution was coated on an electrolytic copper foil by the use of an applicator so that the thickness of the solution layer thereon might be about 100 µm. This copper foil coated with the mixed polyamide acid solution was

fixed on a frame and was then heated at 100 °C, 150 °C and 250 °C, respectively, for 30 minutes and further at 350 °C for 1 hour in an electric oven, thereby preparing a substrate. Adhesive strength between the polyimide film and the copper foil of the substrate was 1.9 kg/cm in terms of peeling strength at an angle of 180 °. Moreover, the curling of the substrate was scarcely seen.

Examples 2 to 6

(1) Synthesis of polyamide acid (A):

The synthesis of a polyamide acid (A) was carried out following the same procedure as in the step (1) of Example 1 with the exception that the kinds and amounts of diamine component and kind of solvent were altered as shown in Table 1.

(2) Synthesis of polyamide acid (B):

The synthesis of a polyamide acid (B) was carried out following the same procedure as in the step (2) of Example 1 with the exception that the kinds and amounts of acid anhydride component and diamine component, and kind of solvent were altered as shown in Table 1.

(3) Substrate:

Each substrate was prepared following the same procedure as in the step (3) of Example 1 with the exception that a mixing ratio of the polyamide acid (A) to the polyamide acid (B) was altered as shown in Table 1.

The results of Examples 2 to 6 are set forth in Table 1.

Comparative Examples 1 to 3

(1) Synthesis of polyamide acid:

Into a 500 milliliter three-necked flask was poured 250 ml of purified solvent, and the atmosphere in the flask was then replaced with nitrogen. Afterward, a predetermined amount of diamine component was added thereto and was then dissolved therein with stirring. After the dissolution, a predetermined amount of an aromatic tetracarboxylic dianhydride was added thereto so as to perform reaction. This reaction was continued at a temperature of 10 °C or less for 5 hours. The molecular weight of each of the thus obtained polymers was represented by an inherent viscosity at 30 °C at a concentration of 0.5 g/100 ml in N-methyl-2-pyrrolidone.

(2) Substrate:

Each of the polyamide acid solutions which had been synthesized in the above-mentioned step (1) was coated on a copper foil having a thickness of 35 µm by the use of an applicator, and the copper foil coated with the polyamide acid solution was then heated at 100 °C, 150 °C and 250 °C, respectively, for 30 minutes, and further at 350 °C for 1 hour in an electric oven, thereby preparing substrates.

The results in Comparative Examples 1 to 3 are set forth in Table 1.

Table 1 (I)

| Example | Polyamide Acid (A) | | | Polyamdie Acid (B) | | |
|---|---|---|---|---|---|---|
| | Acid Anhydride Component*1 (mole) | Diamine Component*1 (mole) | Inherent Viscosity | Acid Anhydride Component*1 (mole) | Diamine Component*1 (mole) | Inherent Viscosity |
| Example 1 | S-BPDA (0.1) | p-PDA (0.08) 4,4'-DDE (0.02) | 1.8 | S-BPDA (0.05) | p-PDA (0.032) APMS-6 (0.016) p-APS (0.003) | 0.3 |
| Example 2 | S-BPDA (0.1) | p-PDA (0.08) 4,4'-DDE (0.02) | 1.9 | S-BPDA (0.05) | p-PDA (0.041) APMS-6 (0.007) p-APS (0.003) | 0.2 |
| Example 3 | S-BPDA (0.1) | p-PDA (0.065) m-PDA (0.015) 4,4'-DDE (0.02) | 1.5 | S-BPDA (0.05) | p-PDA (0.04) APMS-6 (0.007) p-APS (0.005) | 0.2 |

Table 1 (II)

| Example | Solvent*1 | (A)/(B) Weight Mixing Ratio | Film Thickness (μm) | 180° Peeling Strength (kg/cm) | Curling Properties*2 (cm) |
|---|---|---|---|---|---|
| Example 1 | DMAC | 4/1 | 23 | 1.9 | ∞ |
| Example 2 | DMAC | 10/1 | 26 | 1.8 | ∞ |
| Example 3 | NMP | 4/1 | 25 | 2.5 | 40 |

Table 1 (III)

| Example | Polyamide Acid (A) | | | Polyamdie Acid (B) | | |
|---|---|---|---|---|---|---|
| | Acid Anhydride Component*1 (mole) | Diamine Component*1 (mole) | Inherent Viscosity | Acid Anhydride Component*1 (mole) | Diamine Component*1 (mole) | Inherent Viscosity |
| Example 4 | S-BPDA (0.1) | p-PDA (0.08) 3,4'-DDE (0.02) | 1.8 | S-BPDA (0.03) BTDA (0.02) | p-PDA (0.03) m-PDA (0.005) APMS-6 (0.012) p-APS (0.003) | 0.3 |
| Example 5 | S-BPDA (0.1) | p-PDA (0.07) 4,4'-DDE (0.01) 3,4'-DDE (0.01) | 1.5 | S-BPDA (0.03) PMDA (0.02) | p-PDA (0.043) APMS-10 (0.004) p-APS (0.003) | 0.2 |
| Example 6 | S-BPDA (0.1) | p-PDA (0.06) m-PDA (0.01) 4,4'-DDE (0.03) | 1.6 | S-BPDA (0.04) BTDA (0.01) | p-PDA (0.03) m-PDA (0.012) APMS-18 (0.007) APSE (0.001) | 0.4 |

Table 1 (IV)

| Example | Solvent*1 | (A)/(B) Weight Mixing Ratio | Film Thickness (μm) | 130° Peeling Strength (kg/cm) | Curling Properties*2 (cm) |
|---|---|---|---|---|---|
| Example 4 | NMP | 5/1 | 24 | 2.0 | 25 |
| Example 5 | DMAC | 6/1 | 25 | 1.8 | 30 |
| Example 6 | DMAC | 7/1 | 26 | 1.7 | ∞ |

Table 1 (V)

| Comp. Ex. | Polyamide Acid (A) Acid Anhydride Component*1 (mole) | Polyamide Acid (A) Diamine Component*1 (mole) | Polyamide Acid (A) Inherent Viscosity | Polyamdie Acid (B) Acid Anhydride Component*1 (mole) | Polyamdie Acid (B) Diamine Component*1 (mole) | Polyamdie Acid (B) Inherent Viscosity |
|---|---|---|---|---|---|---|
| Comp. Example 1 | S-BPDA (0.1) | p-PDA (0.08) 4,4'-DDE (0.02) | 1.8 | - | - | - |
| Comp. Example 2 | PMDA (0.1) | 4,4'-DDE (0.1) | 1.6 | - | - | - |
| Comp. Example 3 | S-BPDA (0.1) | p-PDA (0.07) 4,4'-DDE (0.0295) p-APS (0.0005) | 1.1 | - | - | - |
| Comp. Example 4 | PMDA (0.1) | 4,4'-DDE (0.1) | 1.5 | S-BPDA (0.05) | p-PDA (0.04) APMS-6 (0.008) p-APS (0.002) | 0.3 |

Table 1 (VI)

| Example | Solvent*1 | (A)/(B) Weight Mixing Ratio | Film Thickness (μm) | 180° Peeling Strength (kg/cm) | Curling Properties*2 (cm) |
|---|---|---|---|---|---|
| Comp. Example 1 | DMAC | - | 25 | 1.3 | 30 |
| Comp. Example 2 | NMP | - | 25 | 0.6 | 2.0 |
| Comp. Example 3 | DMAC | - | 28 | 1.0 | 20 |
| Comp. Example 4 | DMAC | 5/1 | 26 | 0.8 | 4.0 |

Notes regarding Table 1

*1: The abbreviations of the respective components represent the following compounds:

| | |
|---|---|
| S-BPDA: | 3,4,3',4'-Bisphenyltetracarboxylic acid dianhydride |
| PMDA: | Pyromellitic acid dianhydride |
| BTDA: | 3,3,3',4'-Benzophenonetetracarboxylic acid dianhydride |
| p-PDA: | Paraphenylenediamine |
| m-PDA: | Metaphenylenediamine |
| 3,4'-DDE: | 3,4'-Diaminodiphenyl ether |
| 4,4'-DDE: | 4,4'-Diaminodiphenyl ether |
| APMS-6: | $H_2N-(CH_2)_3Si(CH_3)_2[O-Si(CH_3)_2]_4-OSi(CH_3)_2-(CH_2)_3NH_2$ |
| APMS-10: | $H_2N-(CH_2)_3Si(CH_3)_2[O-Si(CH_3)_2]_8-OSi(CH_3)_2-(CH_2)_3NH_2$ |
| APMS-18: | $H_2N-(CH_2)_3Si(CH_3)_2[O-Si(CH_3)_2]_{16}-OSi(CH_3)_2-(CH_2)_3NH_2$ |
| p-APS: | $H_2N$- 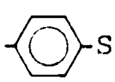 -$Si(OCH_3)_3$ |
| APSE: | $H_2N-(CH_2)_3-Si(OEt)_3$ |
| DMAC: | N,N-dimethylacetamide |
| NMP: | N-methyl-2-pyrrolidone |

*2: Curling properties:

Curling properties were indicated with a curvature radius of the substrate having a size of 10 cm x 10 cm.

## Claims

1. A flexible copper-clad substrate which comprises a copper foil having formed directly on its surface a resin layer of a composite material of (I), a polyimide having repeating units of the formula:

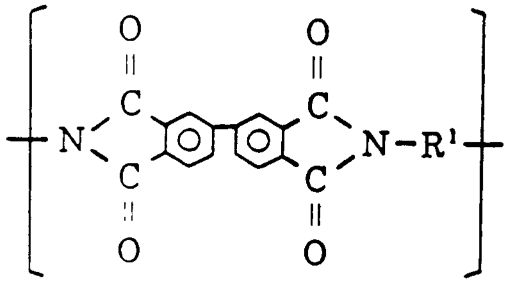

(I)

in which $R^1$ is an aromatic hydrocarbon group

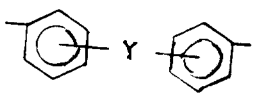

and/or

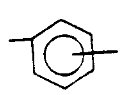

,

in which Y is -O-, -CO-, $-SO_2-$ or $-CH_2-$; and

(II) a silicone polyimide containing repeating units of the formula:

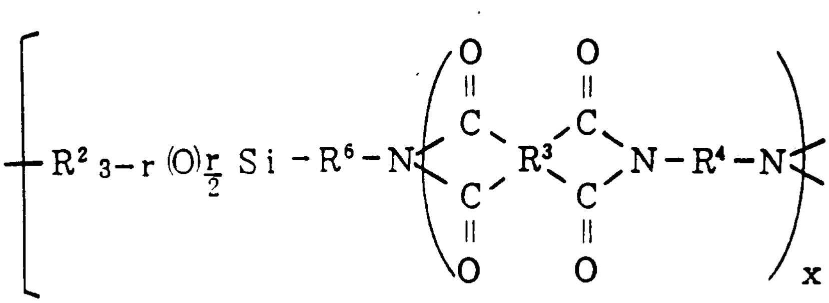

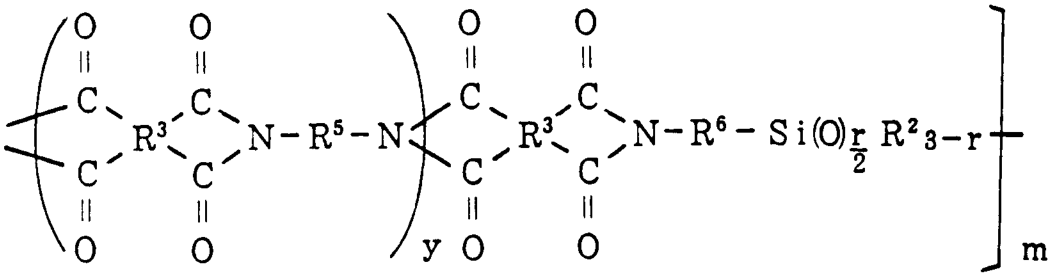

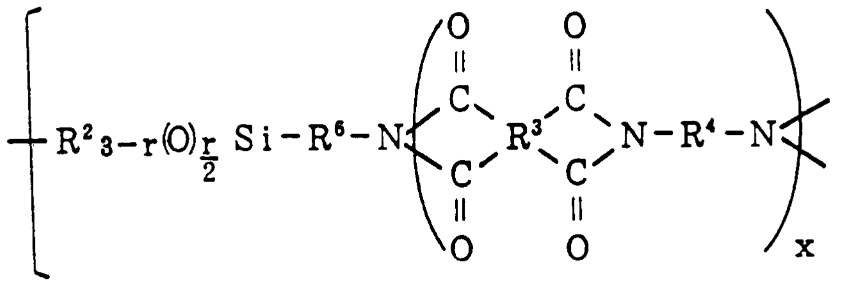

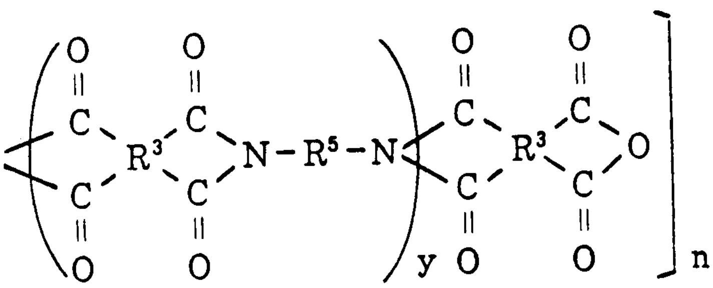

(II)

in which $R^2$ is an aliphatic hydrocarbon group having 5 or less carbon atoms or an aromatic hydrocarbon group hving 9 or less carbon atoms; $R^3$ is a tetravalent aromatic hydrocarbonyl group; $R^4$ is a divalent aromatic hydrocarbon group; $R^5$ is divalent siloxane chain; $R^6$ is a divalent aliphatic hydrocarbon group having 3 to 5 carbon atoms or a divalent aromatic hydrocarbon group having 6 to 9 carbon atoms; r is 2 or 3; the ratio x:y is 97-60: 3-40, and the ratio m:n is 50-100:50-0.

**2.** A substrate according to claim 1 wherein $R^1$ is composed of 5 to 30 mole % of groups of the formula

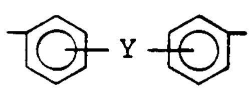

and 70 to 95 mole% of groups of the formula:

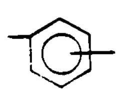

;

$R^2$ is a methyl or phenyl group; and $R^5$ is a group of the formula:

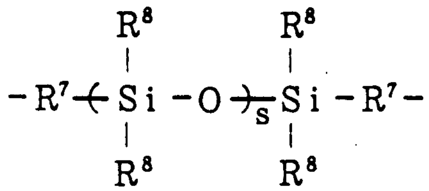 (V)

in which $R^7$ is a divalent aliphatic hydrocarbon group having 3 to 5 carbon atoms or a divalent aromatic hydrocarbon group having 6 to 9 carbon atoms; $R^8$ is an aliphatic hydrocarbon group having 1 to 3 carbon atoms or an aromatic hydrocarbon group having 6 to 9 carbon atoms, and s is an integer of 3 to 150.

**3.** A process for preparing a substrate as claimed in claim 1 which comprises coating a copper foil with a polyamide acid composite solution and then forming the resin layer by heating the coated foil, the composite solution being one prepared by mixing a solution of a polyamide acid having repeating units of the formula:

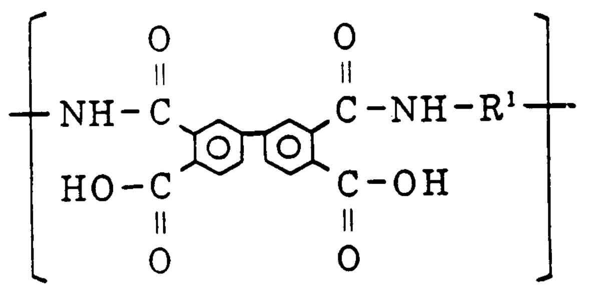 (III)

in which $R^1$ has the meaning defined in claim 1, with a solution of a polyamide acid alkylsilane of the formula:

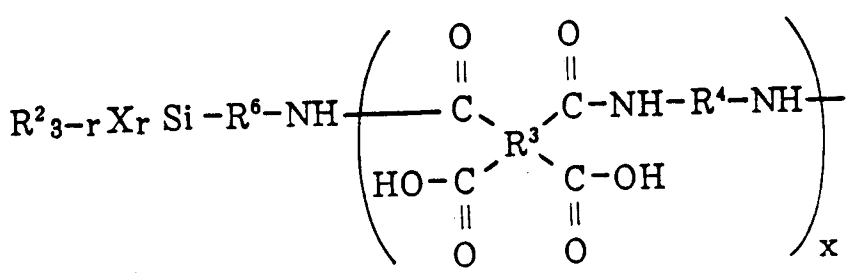

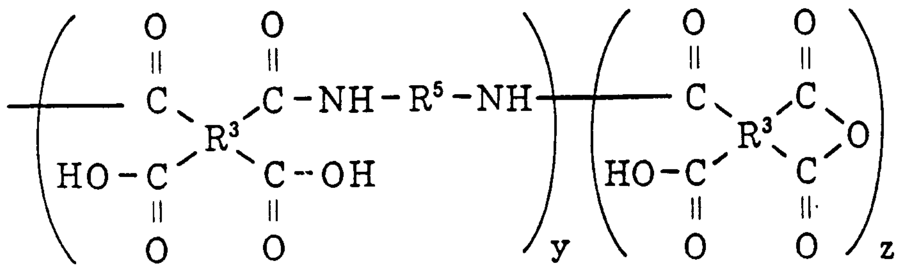

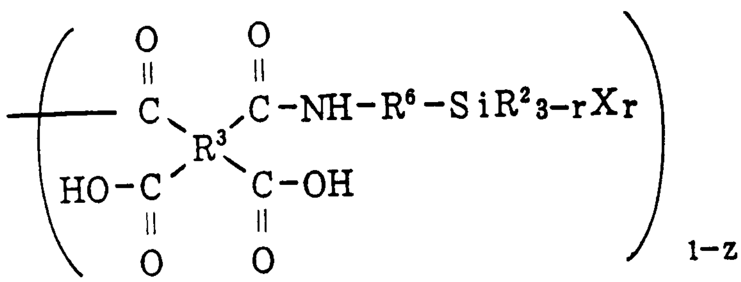

(IV)

in which $R^2$, $R^3$, $R^4$, $R^5$, $R^6$, r, m, n, x and y have the meanings defined in claim 1; X is a hydrolyzable alkoxy group, an acetoxy group or a halogen; and z has a value of 0 to 0.5.

4. A process according to claim 3 in which $R^1$, $R^2$ and $R^5$ have the meanings defined in claim 2.

**Patentansprüche**

1. Flexibles kupferkaschiertes Substrat, welches eine Kupferfolie mit einer direkt auf ihrer Oberfläche gebildeten Kunstharzschicht aufweist, welche Kunstharzschicht einen Verbundstoff aufweist, umfassend (I) ein Polyimid mit Grundeinheiten der Formel:

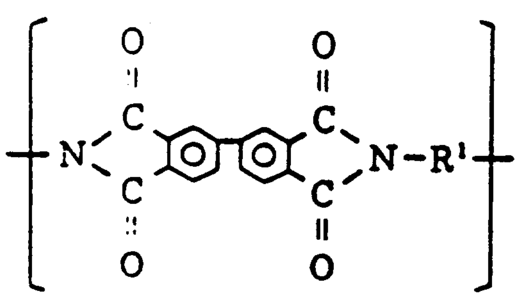

(I)

worin $R^1$ eine aromatische Kohlenwasserstoffgruppe ist

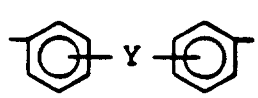 und/oder 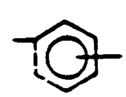

in welcher Y -O-, -CO-, $-SO_2-$ oder $-CH_2-$ ist; und
(II) ein Siliconpolyimid mit Grundeinheiten der Formel:

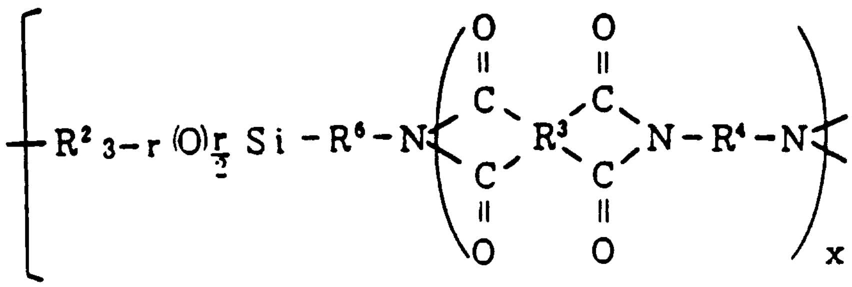

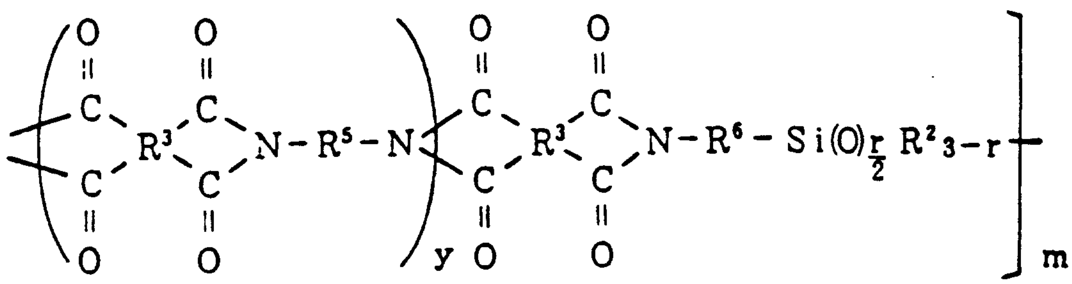

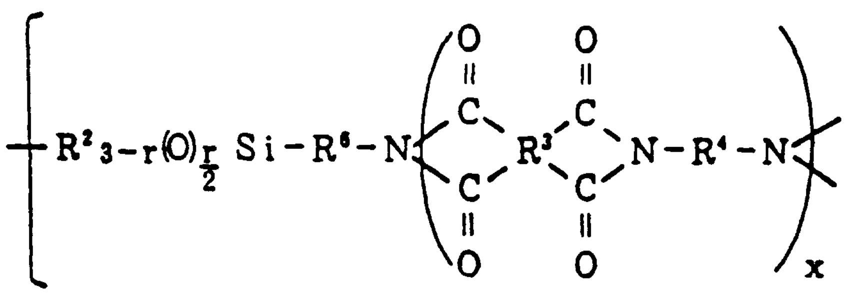

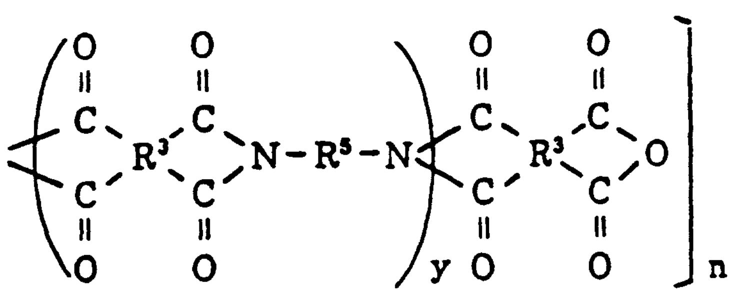

(II)

worin $R^2$ eine aliphatische Kohlenwasserstoffgruppe mit 5 oder weniger Kohlenstoffatomen oder einer aromatischen Kohlenwasserstoffgruppe mit 9 oder weniger Kohlenstoffatomen ist; $R^3$ eine vierwertige aromatische Hydrocarbonylgruppe; $R^4$ eine zweiwertige aromatische Kohlenwasserstoffgruppe; $R^5$ eine zweiwertige Siloxankette; $R^6$ eine zweiwertige aliphatische Kohlenwasserstoffgruppe mit 3 bis 5 Kohlenstoffatomen oder eine zweiwertige aromatische Kohlenwasserstoffgruppe mit 6 bis 9 Kohlenwasserstoffatomen; r 2 oder 3 ist; das Verhältnis von x : y 97 ... 60 beträgt und das Verhältnis von m : n 50 ... 100 : 50 ... 0.

**2.** Substrat nach Anspruch 1, bei welchem $R^1$ aus 5 bis 30 Molprozent Gruppen der Formel

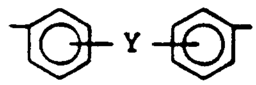

und 70 bis 95 Molprozent Gruppen der Formel

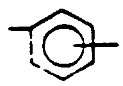

zusammengesetzt ist;

$R^2$ eine Methylgruppe oder Phenylgruppe und R5 eine Gruppe der Formel

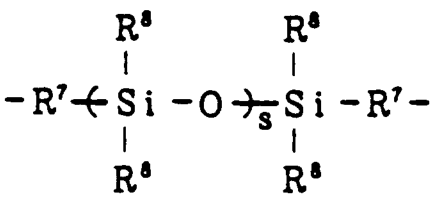

(V)

worin $R^7$ eine zweiwertige aliphatische Kohlenwasserstoffgruppe mit 3 bis 5 Kohlenstoffatomen oder eine zweiwertige aromatische Kohlenwasserstoffgruppe mit 6 bis 9 Kohlenwasserstoffatomen ist; $R^8$ eine aliphatische Kohlenwasserstoffgruppe mit 1 bis 3 Kohlenstoffatomen oder eine aromatische Kohlenwasserstoffgruppe mit 6 bis 9 Kohlenstoffatomen ist und s eine ganze Zahl von 3 bis 150 ist.

**3.** Verfahren zur Herstellung eines Substrats nach Anspruch 1, umfassend:

Beschichten einer Kupferfolie mit einer Polyamidsäure-Verbundstofflösung und sodann Erhitzen der beschichteten Folie, bei welchem die Verbundstofflösung hergestellt wird durch Mischen einer Lösung einer Polyamidsäure, die Grundeinheiten der Formel

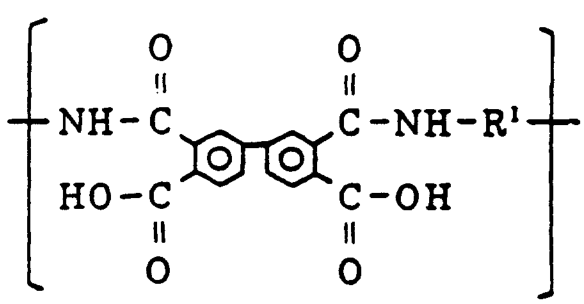

(III)

aufweist, worin $R^1$ die in Anspruch 1 festgelegte Bedeutung hat, mit einer Lösung eines Polyamidsäurealkylsilans der Formel:

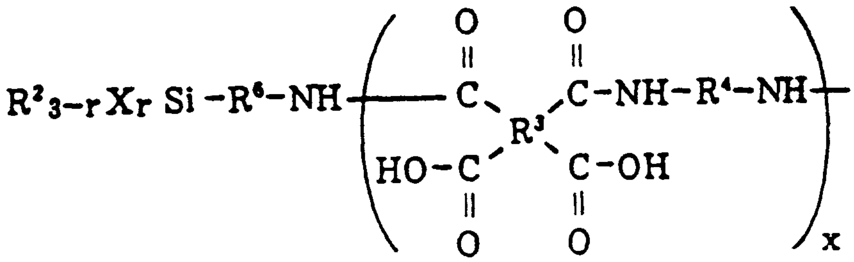

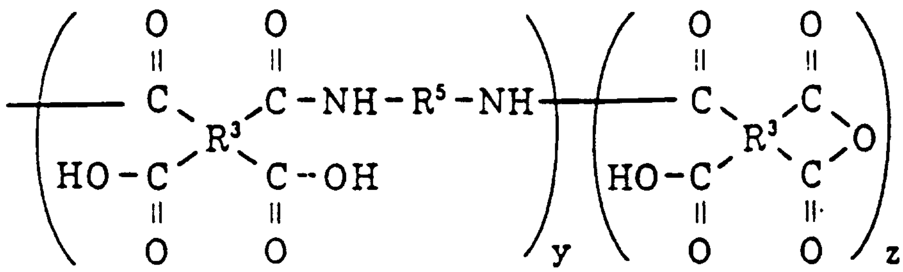

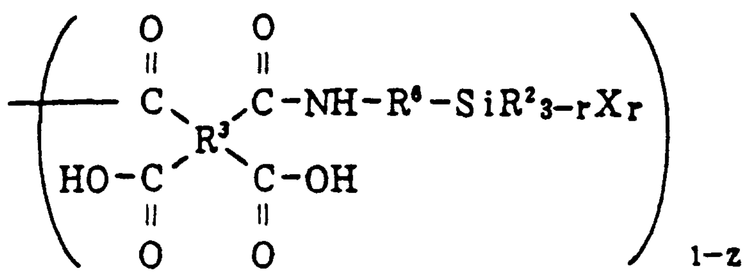

(IV)

worin $R^2$, $R^3$, $R^4$, $R^5$, $R^6$, r, m, n, x und y die in Anspruch 1 festgelegte Bedeutung haben, X eine hydrolysierbare Alkoxygruppe, eine Acetoxygruppe oder ein Halogen ist und z einen Wert von Null bis 0,5 hat.

**4.** Verfahren nach Anspruch 3, bei welchem $R^1$, $R^2$ und $R^5$ die in Anspruch 2 festgelegt Bedeutung haben.

**Revendications**

**1.** Substrat flexible revêtu de cuivre qui comprend une feuille de cuivre ayant une couche de résine directement formée sur sa surface, la couche de résine comprenant un matériau composite comprenant (I) un polyimide ayant des unités répétitives de la formule:

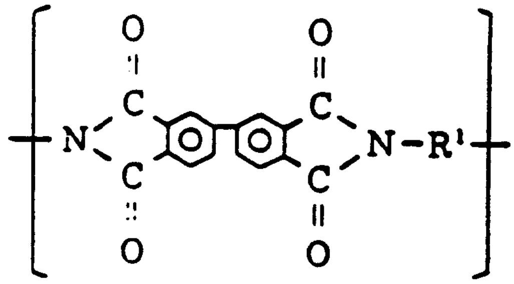

(I)

dans laquelle R[1] est un groupement hydrocarboné aromatique

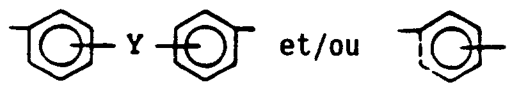

où Y est -O-, -CO-, $-SO_2-$ ou $-CH_2-$ et

(II) un polyimide de silicone contenant des unités répétitives de la formule:

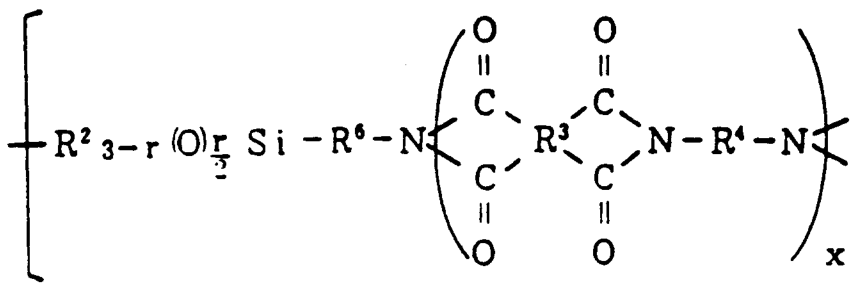

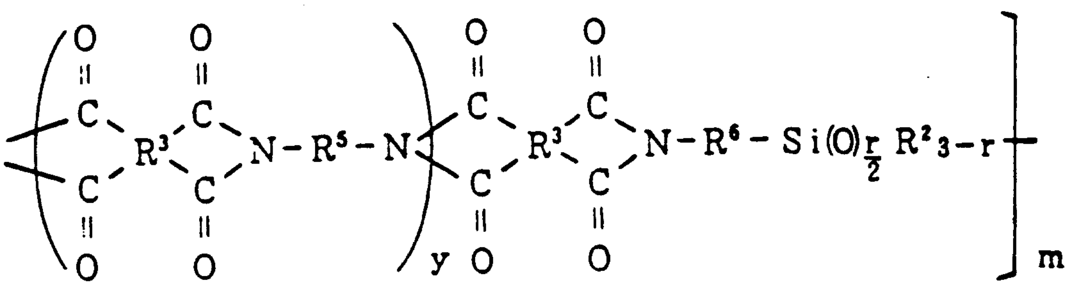

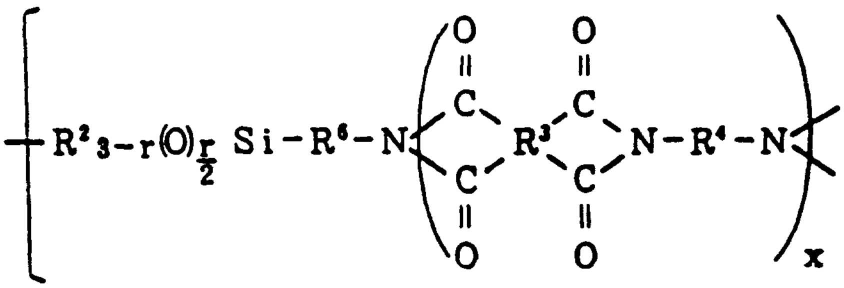

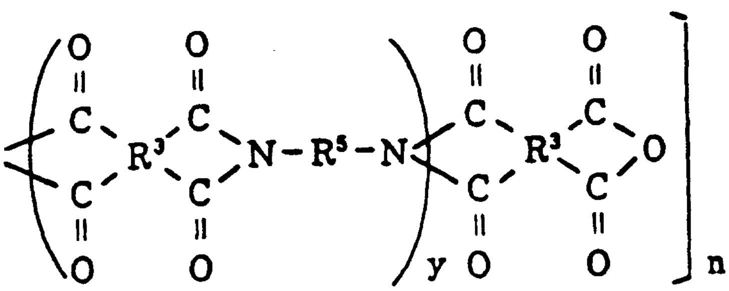

(I)

où $R^2$ est un groupement hydrocarboné aliphatique ayant 5 ou moins de 5 atomes de carbone ou un groupement hydrocarboné aromatique ayant 9 ou moins de 9 atomes de carbone; $R^3$ est un groupement hydrocarbonyle aromatique tétravalent; $R^4$ est un groupement hydrocarboné aromatique divalent; $R^5$ est une chaîne de siloxane divalente; $R^6$ est un groupement hydrocarboné aliphatique divalent ayant de 3 à 5 atomes de carbone ou un groupement hydrocarboné aromatique divalent ayant de 6 à 9 atomes de carbone; r est 2 ou 3; le rapport x:y est 97-60 : 3-40 et le rapport m:n est 50-100 : 50-0.

**2.** Substrat selon la revendication 1, dans lequel $R^1$ est composé de 5 à 30 moles % de groupements de la formule

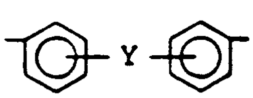

et de 70 à 95 moles % de groupements de la formule

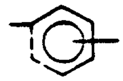 ;

$R^2$ est un groupement méthyle ou phényle et $R^5$ est un groupement de la formule:

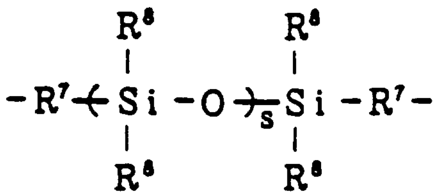 (V)

dans laquelle $R^7$ est un groupement hydrocarboné aliphatique divalent ayant de 3 à 5 atomes de carbone ou un groupement hydrocarboné aromatique divalent ayant de 6 à 9 atomes de carbone; $R^8$ est un groupement hydrocarboné aliphatique ayant de 1 à 3 atomes de carbone ou un groupement hydrocarboné aromatique ayant de 6 à 9 atomes de carbone et s est un nombre entier de 3 à 150.

**3.** Procédé de préparation d'un substrat tel que revendiqué dans la revendication 1, qui comprend le revêtement d'une feuille de cuivre avec une solution de composite acide polyamide et ensuite la formation de la couche de résine par chauffage de la feuille recouverte, dans lequel la solution de composite est une solution préparée par mélange d'une solution d'un acide polyamide ayant des unités répétitives de la formule:

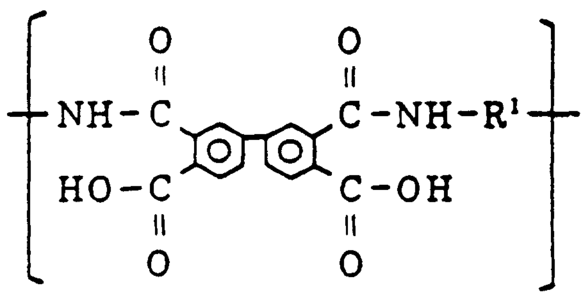 (III)

dans laquelle $R^1$ a la signification qui lui est donnée dans la revendication 1, avec une solution d'un alkylsilane d'acide polyamide de la formule:

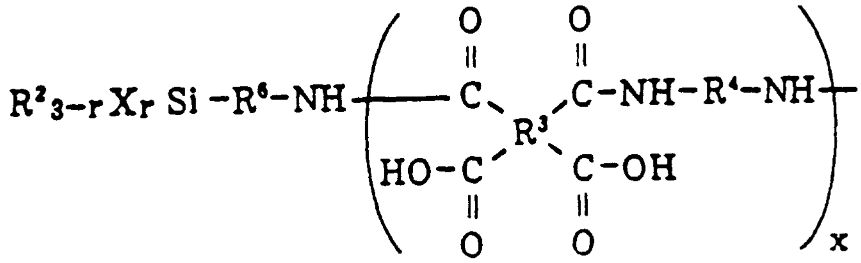

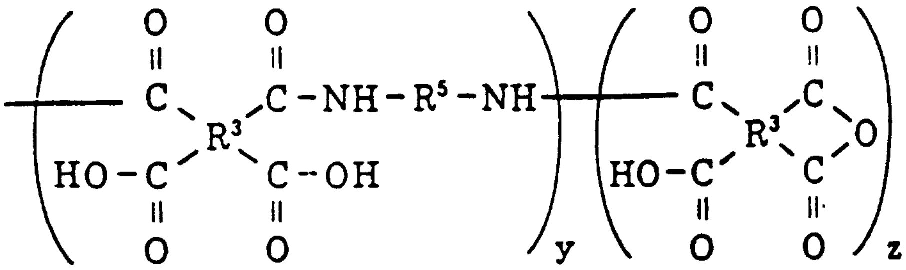

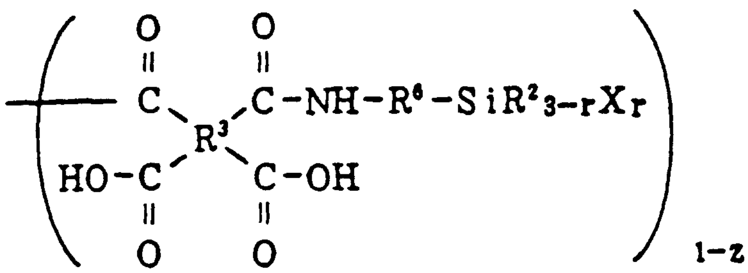

(IV)

où $R^2$, $R^3$, $R^4$, $R^5$, $R^6$, r, m, n, x et y ont les significations qui leurs sont données dans la revendication 1; x est un groupement alcoxy hydrolysable, un groupement acétoxy ou un halogène et z a une valeur de 0 à 0.5.

**4.** Procédé selon la revendication 3, dans lequel $R^1$, $R^2$ et $R^5$ ont les significations qui leur sont données dans la revendication 2.